# EUROPEAN PATENT APPLICATION

(11) **EP 4 507 002 A1**
(43) Date of publication of application: **12.02.2025**
(21) Application number: 24178718.3
(22) Date of filing: 29.05.2024
(51) Int. Cl.: H01L 27/15, H01L 33/00, H01L 33/04, H01L 33/24, H01L 33/06, H01L 33/18, H01L 33/20

(54) **NANOROD LIGHT-EMITTING DEVICE, METHOD OF MANUFACTURING THE SAME, AND DISPLAY APPARATUS INCLUDING THE SAME**

(30) Priority: 07.08.2023 KR 20230103102
(71) Applicant: Samsung Electronics Co., Ltd., Suwon-si, Gyeonggi-do 16677 (KR)
(72) Inventor: CHOI, Junhee, 16678 Suwon-si (KR); KIM, Joosung, 16678 Suwon-si (KR); SHIN, Dongchul, 16678 Suwon-si (KR); PARK, Junghun, 16678 Suwon-si (KR)
(74) Representative: Elkington and Fife LLP

(57) **Abstract**

Provided is a nanorod light-emitting device including a support layer, a first-type semiconductor nanocore protruding from an upper surface of the support layer and including a semiconductor material doped as a first conductivity type, a mask layer on an upper surface of the support layer and extending to a first height of the first-type semiconductor nanocore in a vertical direction and adjacent to a surface of the first-type semiconductor nanocore, a light-emitting layer having a multi-quantum well structure adjacent to a portion of the first-type semiconductor nanocore above the first height in the vertical direction, and a second-type semiconductor layer adjacent to a surface of the light-emitting layer and including a semiconductor material doped as a second conductivity type.

## Description

### FIELD OF THE INVENTION

Example embodiments of the present disclosure relate to a nanorod light-emitting device, a method of manufacturing the same, and a display apparatus including the nanorod light-emitting device.

### BACKGROUND OF THE INVENTION

Light emitting diodes (LEDs) are light sources with advantages such as relatively long lifespan, low power consumption, fast response speed, and environmental friendliness compared to related light sources, and due to these advantages, industrial demand is increasing. LEDs are used in various products such as lighting devices and backlights of display apparatuses.

Recently, micro-unit or nano-unit ultra-small LEDs using Group II-VI or Group III-V compound semiconductors are being developed. In addition, micro-LED displays to which the ultra-small LEDs are directly applied as light-emitting elements of display pixels are being developed. However, when LEDs are miniaturized to micro or nano units, the light emission efficiency of the LEDs may decrease.

### SUMMARY OF THE INVENTION

One or more example embodiments provide a nanorod light-emitting device having a nanoscale diameter and improved light emission efficiency, a manufacturing method thereof, and a display apparatus including the nanorod light-emitting device.

Additional aspects will be set forth in part in the description which follows and, in part, will be apparent from the description, or may be learned by practice of the presented embodiments of the disclosure.

According to an aspect of an example embodiment, there is provided a nanorod light-emitting device including a support layer, a first-type semiconductor nanocore protruding from an upper surface of the support layer and including a semiconductor material doped as a first conductivity type, a mask layer on an upper surface of the support layer and extending to a first height of the first-type semiconductor nanocore in a vertical direction and adjacent to a surface of the first-type semiconductor nanocore, a light-emitting layer having a multi-quantum well structure adjacent to a portion of the first-type semiconductor nanocore above the first height in the vertical direction, and a second-type semiconductor layer adjacent to a surface of the light-emitting layer and including a semiconductor material doped as a second conductivity type.

The support layer and the first-type semiconductor nanocore may be integrally formed.

A first end of the mask layer may have a tapered shape.

The first height may be greater than or equal to 5 % of a height of the first-type semiconductor nanocore.

The nanorod light-emitting device may further include an insulating layer extending from a lower surface of the mask layer to a second height of the first-type semiconductor nanocore in the vertical direction and adjacent to the mask layer and the light-emitting layer.

The second height may be greater than the first height.

The first-type semiconductor nanocore may include a first portion having a uniform cross-sectional area in a horizontal direction perpendicular to the vertical direction of the first-type semiconductor nanocore, and a second portion having a cross-sectional area in the horizontal direction decreasing in the vertical direction away from the support layer.

A region of the light-emitting layer and a region of the second-type semiconductor layer on the second portion may be a light emission disabling region.

The nanorod light-emitting device may further include a hard mask layer on top of the first-type semiconductor nanocore.

The nanorod light-emitting device may further include a super lattice layer between the first-type semiconductor nanocore and the light-emitting layer.

The nanorod light-emitting device may further include an electron blocking layer between the light-emitting layer and the second-type semiconductor layer.

The first-type semiconductor nanocore, the light-emitting layer, and the second-type semiconductor layer may include a Group III-V nitride semiconductor material.

The nanorod light-emitting device may be configured to emit red light and an internal quantum efficiency of the nanorod light-emitting device is greater than 20 %.

According to another aspect of an example embodiment, there is provided a display apparatus including a plurality of pixel electrodes, a common electrode corresponding to the plurality of pixel electrodes, and a plurality of nanorod light-emitting devices connected between each pixel electrode of the plurality of pixel electrodes and the common electrode, wherein each nanorod light-emitting device of the plurality of nanorod light-emitting devices includes a support layer, a first-type semiconductor nanocore protruding from an upper surface of the support layer and including a semiconductor material doped as a first conductivity type, a mask layer on an upper surface of the support layer and extending to a first height of the first-type semiconductor nanocore in a vertical direction and adjacent to a surface of the first-type semiconductor nanocore, a light-emitting layer having a multi-quantum well structure adjacent to a portion of the first-type semiconductor nanocore above the first height in the vertical direction; and a second-type semiconductor layer adjacent to a surface of the light-emitting layer and including a semiconductor material doped as a second conductivity type.

According to another aspect of an example embodiment, there is provided a method of manufacturing a nanorod light-emitting device, the method including forming a first-type semiconductor nanocore protruding from a support layer in a first direction, forming a mask layer adjacent to lower sides of the first-type semiconductor nanocore, and growing a light-emitting structure layer from a surface of the first-type semiconductor nanocore in a direction different from the first direction.

The forming of the first-type semiconductor nanocore may include wet etching a semiconductor substrate.

The method may further include, after forming a hard mask layer on the semiconductor substrate, patterning the semiconductor substrate and the hard mask layer together.

The growing of the light-emitting structure layer may include sequentially forming a super lattice layer, a light-emitting layer, an electron blocking layer, and a second-type semiconductor layer.

The method may further include, after the growing of the light-emitting structure layer, disabling light emission of the light-emitting structure layer formed on a semi-polar surface on a top of the first-type semiconductor nanocore, among the light-emitting structure layer.

The method may further include, after growing the light-emitting structure layer, forming an insulating layer adjacent to an end of the mask layer and the light-emitting structure layer.

### BRIEF DESCRIPTION OF THE DRAWINGS

The above and other aspects, features, and advantages of example embodiments of the disclosure will be more apparent from the following description taken in conjunction with the accompanying drawings, in which:
FIG. 1 is a schematic cross-sectional view of a structure of a nanorod light-emitting device according to an example embodiment;
FIG. 2 is a schematic cross-sectional view of a structure of a nanorod light-emitting device according to another example embodiment;
FIG. 3 is a schematic cross-sectional view of a structure of a nanorod light-emitting device according to another example embodiment;
FIGS. 4A, 4B, 4C, 4D, 4E, 4F, 4G, 4H, 4I, and 4J are diagrams illustrating a method of manufacturing a nanorod light-emitting device, according to an example embodiment;
FIGS. 5A, 5B, and 5C are diagrams illustrating a method of manufacturing a nanorod light-emitting device according to another example embodiment;
FIGS. 6A, 6B, 6C, 6D, 6E, 6F, 6G, 6H, 6I, and 6J are diagrams illustrating a method of manufacturing a nanorod light-emitting device, according to another example embodiment;
FIGS. 7a and 7b are micrographs of a nanorod light-emitting device manufactured according to the method of manufacturing a nanorod light-emitting device, according to an example embodiment;
FIG. 8 is a conceptual diagram schematically showing a configuration of a display apparatus according to an example embodiment;
FIG. 9 is a schematic block diagram of an electronic apparatus according to an example embodiment;
FIG. 10 shows an example of an application of a display apparatus according to an example embodiment to a mobile device;
FIG. 11 shows an example of an application of a display apparatus according to an example embodiment to a vehicle display apparatus;
FIG. 12 shows an example of an application of a display apparatus according to an example embodiment to augmented reality glasses or virtual reality glasses;
FIG. 13 shows an example of an application of a display apparatus according to an example embodiment to a signage; and
FIG. 14 shows an example of an application of a display apparatus according to an example embodiment to a wearable display.

### DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, example embodiments will be described in detail with reference to the accompanying drawings. In addition, example embodiments may be variously modified and may be embodied in many different forms. In the drawings, like reference numerals refer to like elements throughout, and sizes of elements in the drawings may be exaggerated for clarity and convenience of explanation.

When an element or layer is referred to as being "on" or "above" another element or layer, the element or layer may be directly on another element or layer or intervening elements or layers.

Although the terms "first", "second", etc. may be used herein to describe various elements, these terms are only used to distinguish one element from another. These terms do not limit the difference in material or structure of the constituent elements.

The singular forms are intended to include the plural forms as well, unless the context clearly indicates otherwise. When a part "comprises" or "includes" an element in the specification, unless otherwise defined, it is not excluding other elements but may further include other elements.

Also, in the specification, the terms "units" or "...modules" denote units or modules that process at least one function or operation, and may be realized by hardware, software, or a combination of hardware and software.

The term "above" and similar directional terms may be applied to both singular and plural.

With respect to operations that constitute a method, the operations may be performed in any appropriate sequence unless the sequence of operations is clearly described or unless the context clearly indicates otherwise. The use of any and all examples, or exemplary language provided herein, is intended merely to better illuminate the disclosure and does not pose a limitation on the scope of the disclosure unless otherwise claimed.

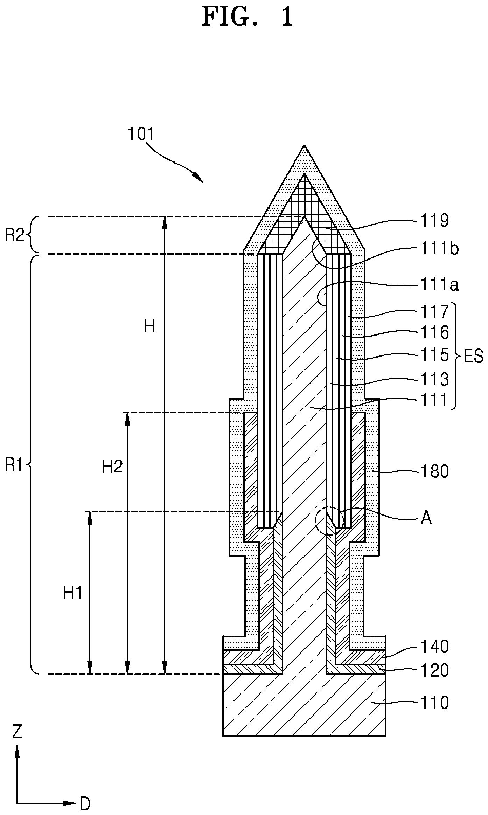

FIG. 1 is a schematic cross-sectional view of a structure of a nanorod light-emitting device 101 according to an example embodiment.

The nanorod light-emitting device 101 may include a support layer 110, a mask layer 120 that is adjacent to and surrounds a surface of a first-type semiconductor nanocore 111 below a predetermined height in a vertical direction (Z direction), the first-type semiconductor nanocore protruding from an upper surface of the support layer 110 and including a semiconductor material doped as a first conductivity type, a light-emitting layer 115 that is adjacent to and surrounds a portion of the first-type semiconductor nanocore 111 that is not surrounded by the mask layer 120, and a second-type semiconductor layer 117 including a semiconductor material doped to a second conductivity type. A superlattice layer 113 may further be formed between the first-type semiconductor nanocore 111 and the light-emitting layer 115, and an electron blocking layer 116 may further be formed between the light-emitting layer 115 and the second-type semiconductor layer 117.

The support layer 110 and the first-type semiconductor nanocore 111 may have an integrated structure based on the same semiconductor substrate. For example, the support layer 110 and the first-type semiconductor nanocore 111 may be formed by etching a gallium nitride (GaN) substrate doped with an N-type dopant. The material of the first-type semiconductor nanocore 111 is not limited thereto, and may include, for example, at least one semiconductor material selected from among n-AlGaN, n-AlInGaN, n-AlGaN, and n-GaN. For example, silicon (Si) may be used as the n-type dopant.

The second-type semiconductor layer 117 may include at least one semiconductor material selected from among p-AlGaN, p-AlInGaN, p-AlGaN, and p-GaN. For example, magnesium (Mg), zinc (Zn), or beryllium (Be) may be used as the p-type dopant.

The light-emitting layer 115 may have a multi-quantum well (MQW) structure. The MQW structure is a structure in which a plurality of quantum well layers and a plurality of barrier layers are alternately disposed. Electrons and holes provided from the first-type semiconductor nanocore 111 and the second-type semiconductor layer 117 are recombined within a quantum well in the light-emitting layer 115, and thus, light may be generated. A wavelength of light emitted from the light-emitting layer 115 may be determined according to an energy band gap of a material constituting the quantum well in the light-emitting layer 115. A thickness of the light-emitting layer 115 or the number of quantum wells in the light-emitting layer 115 may be appropriately selected in consideration of a driving voltage and the light emission efficiency of the nanorod light-emitting device 101.

The light-emitting layer 115 may include a quantum well layer including indium gallium nitride (InGaN) and a barrier layer including GaN. The pair of quantum well layer and barrier layer is not limited thereto, and may include InGaN/InGaN, indium gallium nitride/aluminum gallium nitride (InGaN/AlGaN), or indium gallium nitride/indium aluminum gallium nitride (InGaN/InAlGaN), but the component ratio of each element may be appropriately adjusted. For example, a quantum well layer including InxGa1-xN (0.25≤x<1) and a barrier layer including InyGa1-yN (0≤y<0.15) may form a pair. The content of indium (In) in the quantum well layer may be determined in consideration of a desired emission wavelength.

The superlattice layer 113 may have a structure in which two types of thin films forming a pair are repeatedly arranged dozens of times. For example, a first layer including a material such as the first-type semiconductor nanocore 111 and a second layer including a material such as the light-emitting layer 115 may be alternately arranged dozens of times. For example, the first layer may include GaN, and the second layer may include InyGa1-yN (0 <= y < 0.15). This superlattice layer 113 may relieve stress due to a difference in lattice constant between the first-type semiconductor nanocore 111 and the light-emitting layer 115.

An electron blocking layer (EBL) 116 may be disposed between the light-emitting layer 115 and the second-type semiconductor layer 117. The electron blocking layer 116 may include a semiconductor material doped as the same conductivity type as the second-type semiconductor layer 117.

Additionally, a semiconductor layer doped as the first conductivity type may further be formed on a surface of the first-type semiconductor nanocore 111.

As shown in FIG. 1, the first-type semiconductor nanocore 111 may have a shape including a first portion R1 in which a cross-sectional area in a horizontal direction (D direction) perpendicular to a height direction (Z direction) is constant and a second portion R2 in which a cross-sectional area that is perpendicular to the height direction decreases with height. A first surface 111a of the first portion R1 is a non-polar surface, but a second surface 111b of the second portion R2 is a semi-polar surface, thus, a light-emitting structure formed in the second surface 111b, which is an inclined surface, may have relatively low light emission efficiency. In addition, the uppermost part of the second portion R2 may have low thin film quality because a Group III semiconductor material may not move smoothly. In the nanorod light-emitting device 101 according to an example embodiment, a light emission disabling region 119 may be formed on the second portion R2. The light emission disabling region 119 may be formed by increasing a point defect concentration through ion implantation in the light-emitting structure formed on the second portion R2.

In the nanorod light-emitting device 101 according to the example embodiment, a light-emitting structure layer (ES) is formed at a position above a predetermined height of the first-type semiconductor nanocore 111. To this end, as shown in FIG. 1, the mask layer 120 is formed to extend from the upper surface of the support layer 110 to a first height H1 of the first-type semiconductor nanocore 111 to surround the first-type semiconductor nanocore 111. Accordingly, the light-emitting structure layer ES is formed at a position equal to or higher than the first height H1 in the vertical direction (Z direction). One end of the mask layer 120, that is, an end of the first height H1 may have a tapered shape. This shape is due to a difference in etch rate with a photoresist material used in a process of forming the mask layer 120 to the first height H1. However, the shape of one end of the mask layer 120 is not limited thereto.

The mask layer 120 may include, as an insulating material, silicon oxide or silicon nitride, and may include, for example, silicon oxide (SiO₂), titanium oxide (TiO₂), silicon nitride (Si3N₄), aluminum oxide (Al₂O₃), titanium nitride (TiN), aluminum nitride (AIN), zinc oxide (ZrO₂), titanium aluminum nitride (TiAlN), titanium silicon nitride (TiSiN), etc.

The first height H1 may be 5% or more of the height H of the first-type semiconductor nanocore 111.

The purpose of forming the mask layer 120 in this way is to reduce defects that may occur at a lower location of the first-type semiconductor nanocore 111. An example of such a defect is, for example, the formation of abnormal big GaN. The first height H1 may be determined as small as possible to prevent such defects. For example, the first height H1 may be 5% or more, 30% or less, 20% or less, or 10% or less of the height H of the first-type semiconductor nanocore 111.

The nanorod light-emitting device 101 may further include an insulating layer 140 extending from a lower surface of the mask layer 120 to a position of a second height H2 of the first-type semiconductor nanocore 111 and surrounding the mask layer 120 and the light-emitting layer 115.

The insulating layer 140 may prevent leakage current that may occur between an end of the mask layer 120 and the light-emitting structure layer ES, for example, in a region marked A. The second height H2 may be greater than the first height H1. The second height H2 is greater than the first height H1 but may be set as small as possible within a range that may prevent leakage current.

Similar to the nanorod light-emitting device 101 according to an example embodiment, in the light-emitting structure surrounding a surface of the first-type semiconductor nanocore 111 and grown in a direction perpendicular to the height direction (Z direction), a m-plane, that is, a non-polar surface is a growth plane, and thus, internal quantum efficiency may be increased compared to a structure in which a c-plane, that is, a polar surface is a growth surface.

The first surface 111a of the first-type semiconductor nanocore 111 is a non-polar surface, the light-emitting layer 115 grown therefrom has almost no spontaneous polarization, accordingly, the quantum confinement stark effect (QCSE) due to a polarization field is reduced, and as a result, there is almost no electron/hole space separation problem. In addition, because a size of the formed structure is a nanoscale in which strain is relieved, polarization due to the piezoelectric field effect may be suppressed, thereby suppressing the quantum confinement stark effect (QCSE). The piezoelectric field effect may also cause blue shift due to current increases.

The nanorod light-emitting device 101 according to an example embodiment has a structure that minimizes the causes of such reduction in light emission efficiency, and accordingly, light emission efficiency may be increased. In addition, the phenomenon that crystal defects are induced as the content of indium (In) increases is also reduced, thus, it is easier to maintain a uniform In content, and the issue of a relatively large full width at half maximum due to indium agglomeration is also reduced. As a result, a full width at half maximum of an emission spectrum may also become smaller.

In the case of related embodiment in which nanocores are selectively grown in a structure without a mask layer 120 such as that provided in the nanorod light-emitting device 101 according to an example embodiment, and the light-emitting layer is grown on a growth surface of a polar plane or a semi-polar plane, light emission efficiency may be very low. For example, a red LED using AlGaInP as a light-emitting layer has high efficiency at sizes larger than 100 um x 100 um, but as the size decreases, the efficiency decreases rapidly, and the external quantum efficiency (EQE) is less than 0.5%. LEDs that use InGaN as a light-emitting layer are relatively less affected by size, but in the red wavelength band where the indium (In) content increases, the internal quantum efficiency (IQE) is less than 20% due to defects of lattice mismatch, and the external quantum efficiency (EQE) is less than 5%.

The internal quantum efficiency of the nanorod light-emitting device 101 according to an example embodiment may be greater than 20%, 25% or more, or may reach about 30%.

The internal quantum efficiency of the nanorod light-emitting device 101 according to an example embodiment may be greater than 20%, 25% or more, or may reach about 30% even when the material of the light-emitting layer 115 is set to emit red light.

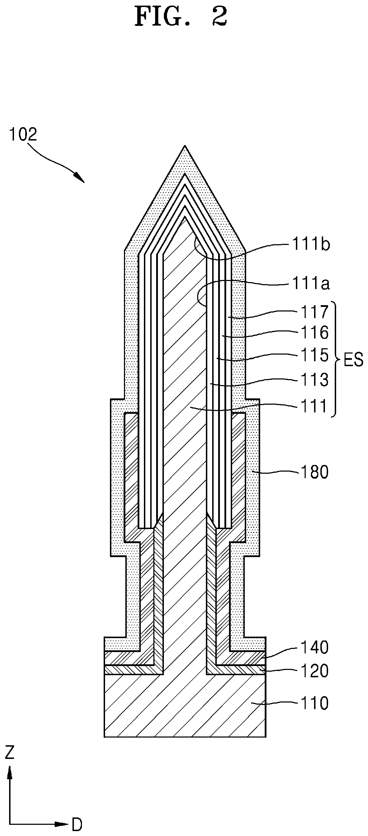

FIG. 2 is a schematic cross-sectional view of a structure of a nanorod light-emitting device 102 according to another example embodiment.

The nanorod light-emitting device 102 according to another example embodiment differs from the nanorod light-emitting device 101 of FIG. 1 in that the light emission disabling region 119 provided in the nanorod light-emitting device 101 of FIG. 1 is not formed.

For example, the light-emitting structure layer (ES) formed on the second surface 111b of the first-type semiconductor nanocore 111 is maintained as is. Because the second surface 111b is a semi-polar surface, a light-emitting structure formed on the semi-polar surface may exhibit higher effect than a light-emitting structure formed on a polar surface. Additionally, depending on the process, the quality of a thin film at the top of the first-type semiconductor nanocore 111 may be improved, and a light-emitting structure of this part may also be utilized to contribute to light emission.

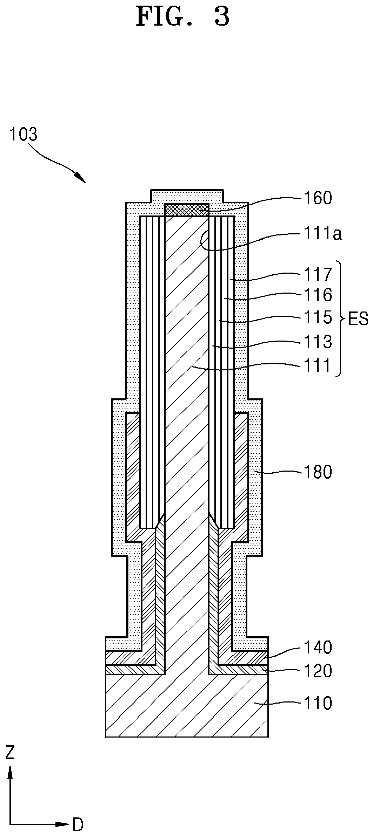

FIG. 3 is a schematic cross-sectional view of a structure of a nanorod light-emitting device 103 according to another example embodiment.

The nanorod light-emitting device 103 according to another example embodiment is different from the nanorod light-emitting devices 101 and 102 described above in that the nanorod light-emitting device 103 further includes a hard mask layer 160 at the top of the first-type semiconductor nanocore 111 and the first-type semiconductor nanocore 111 includes only the first surface 111a, which is a non-polar surface.

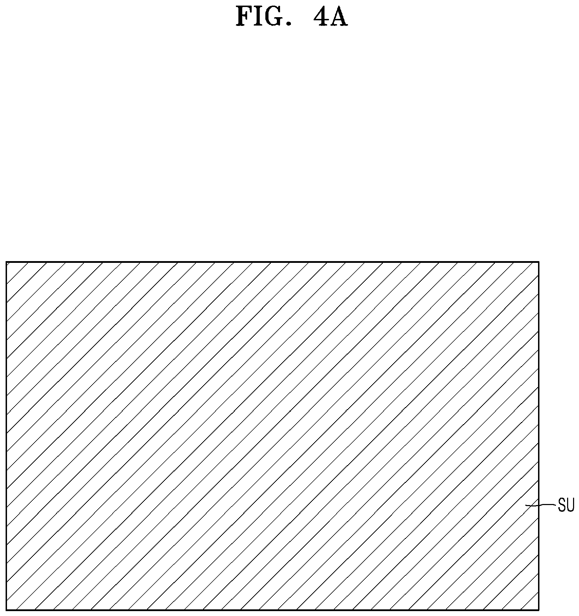

FIGS. 4A to 4J are diagrams illustrating a method of manufacturing a nanorod light-emitting device according to an example embodiment.

Referring to FIG. 4A, a semiconductor substrate SU may be provided. The semiconductor substrate SU may include an n-type doped semiconductor material. The semiconductor substrate SU may be, for example, an n-GaN substrate.

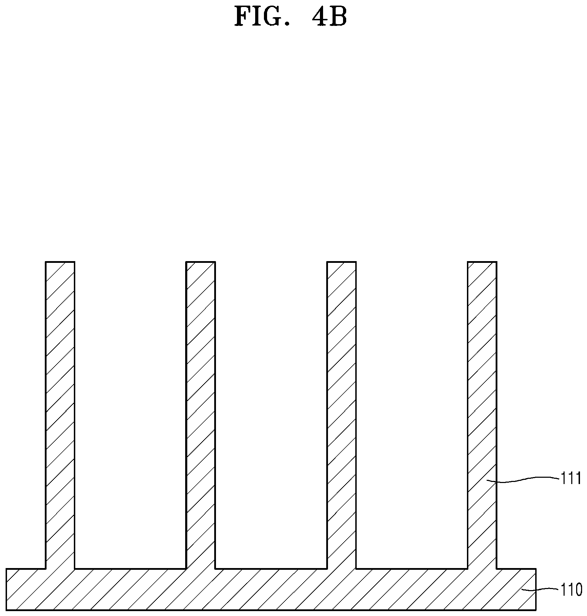

Referring to FIG. 4B, a structure in which a plurality of first-type semiconductor nanocores 111 protrude is formed on the support layer 110. The structure of FIG. 4B may be formed by patterning and etching the substrate SU of FIG. 4A. For example, to form the structure, a wet etching method using a tetramethyl ammonium hydroxide (TMAH) solution or a KOH solution as an etchant may be used.

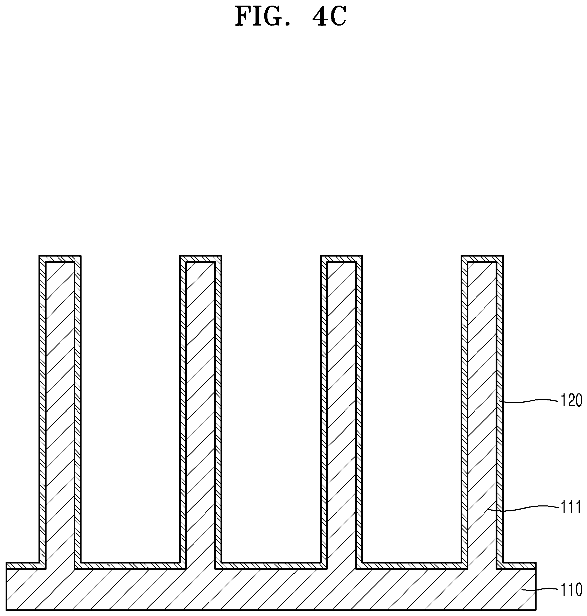

Referring to FIG. 4C, a mask layer 120 is formed along surfaces of the first-type semiconductor nanocores 111. The mask layer 120, as an insulating material, may include silicon oxide or silicon nitride, for example, SiO₂, TiO₂, Si3N₄, Al₂O₃, TiN, AlN, ZrO₂, TiAlN, TiSiN, etc. and may be formed by using an ALD method. The mask layer 120 may be conformally formed along a surface of the support layer 110 and the surfaces of the plurality of first-type semiconductor nanocores 111.

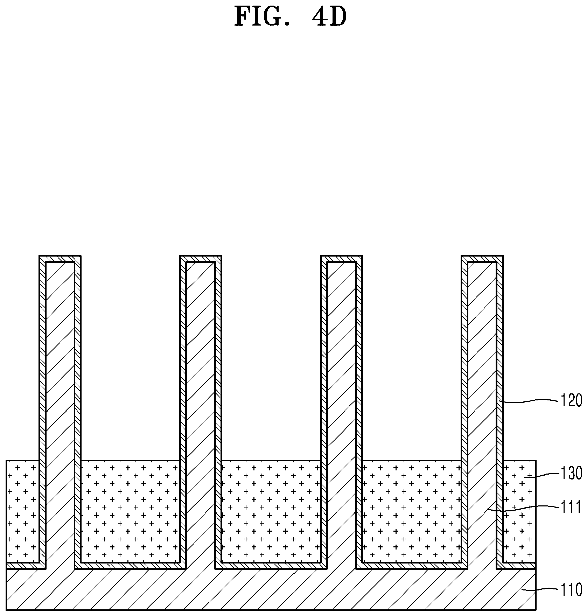

Referring to FIG. 4D, a photoresist layer 130 is formed. The photoresist layer 130 with a height shown may be formed by coating a photoresist material and ashing.

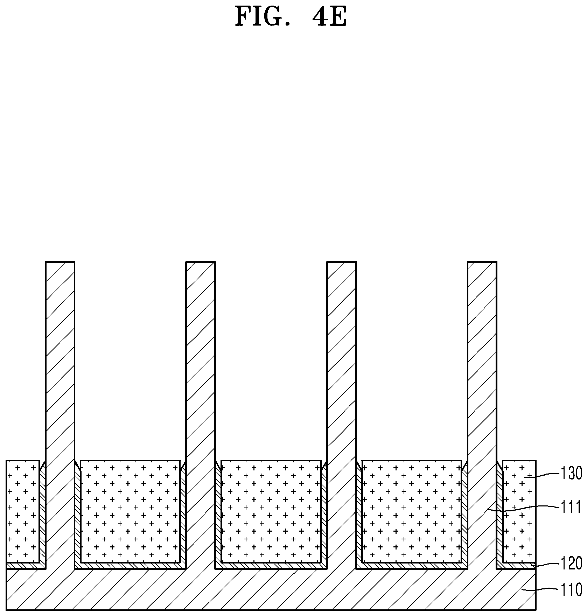

Referring to FIG. 4E, a portion of the mask layer 120 that is higher than the photoresist layer 130 is etched. A wet etching method using an etchant having a relatively high etch selectivity with respect to the material of the mask layer 120 may be used. Due to the difference in etch selectivity, an upper end of the mask layer 120 may be etched more than the photoresist layer 130, resulting in a tapered shape.

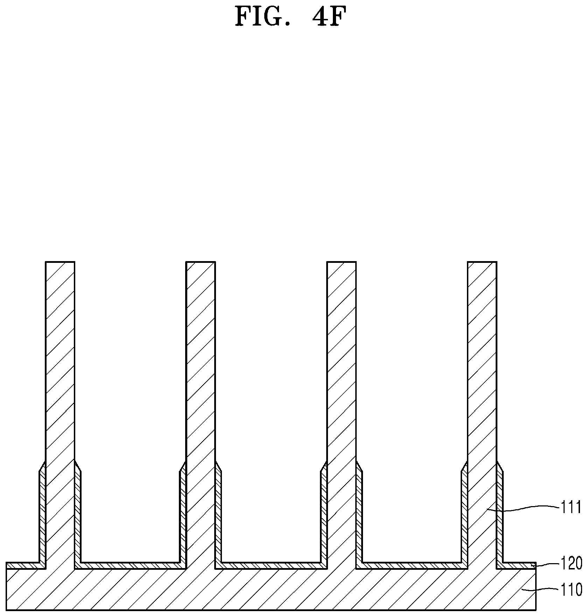

Referring to FIG. 4F, the photoresist layer 130 is removed.

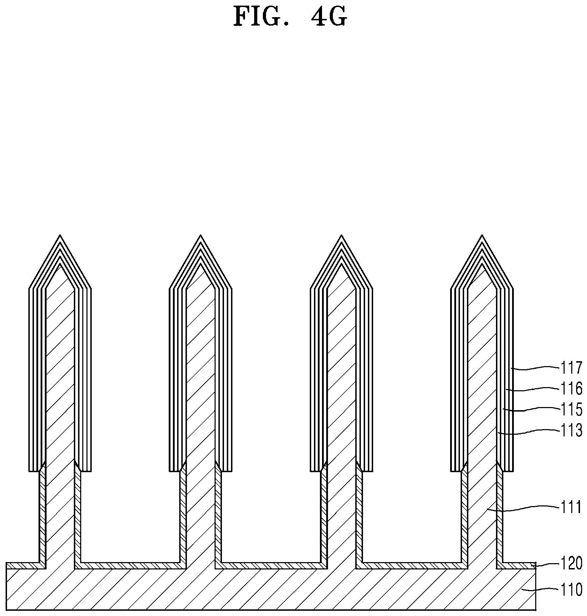

Referring to FIG. 4G, a light-emitting layer 115 is grown from the surface of the first-type semiconductor nanocore 111. As shown in FIG. 4G, a superlattice layer 113, a light-emitting layer 115, an electron blocking layer 116, and a second-type semiconductor layer 117 may be sequentially formed in a shape surrounding a first surface 111a of the first-type semiconductor nanocore 111. To form these semiconductor layers, for example, a hybrid vapor phase epitaxy (HVPE) method, a molecular beam epitaxy (MBE) method, a metal organic vapor phase epitaxy (MOVPE) method, a metal organic chemical vapor deposition (MOCVD) method, etc. may be used.

In the manufacturing process, the first-type semiconductor nanocore 111 may further be grown in a height direction, and thus, may have a shape having a semi-polar second surface 111b in addition to the non-polar first surface 111a. The superlattice layer 113, the light emitting layer 115, the electron blocking layer 116, and the second-type semiconductor layer 117 may also be sequentially formed on the second surface 111b.

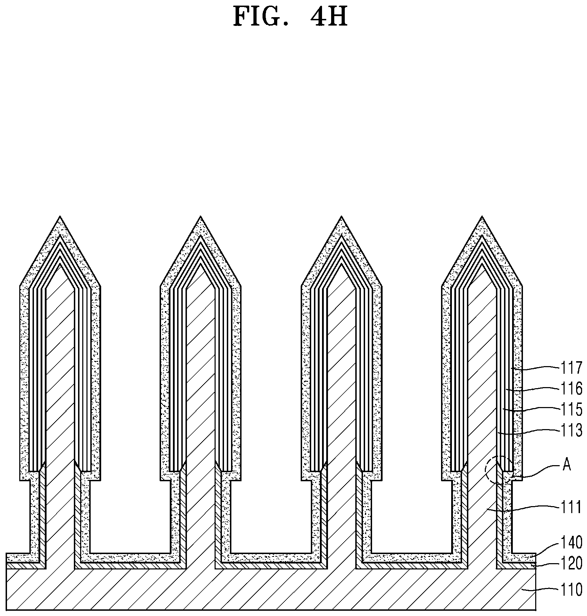

Referring to FIG. 4H, an insulating layer 140 is conformally formed on the structure shown in FIG. 4G. The insulating layer 140 is formed to prevent leakage current that may occur near an end of the mask layer 120, that is, near a region marked A.

The insulating layer 140 may include, for example, zirconium oxide (ZrO), strontium oxide (SrO), magnesium oxide (MgO), barium oxide (BaO), cerium oxide (CeO₂), gadolium oxide (Gd₂O₃), calcium oxide (CaO), hafnium oxide (HfO₂), titanium oxide (TiO₂), aluminum oxide (AlOₓ), barium nitride (BaN), silicon nitride (SiN), titanium nitride (TiN), cerium nitride (CeN), aluminum nitride (AlN), zinc selenide (ZnSe), zinc sulfide (ZnS), aluminum gallium nitride (AlGaN), or AlₓGa₁₋ₓAs (x ≥ 0.9). The insulating layer 140 may be formed using an atomic layer deposition (ALD) method.

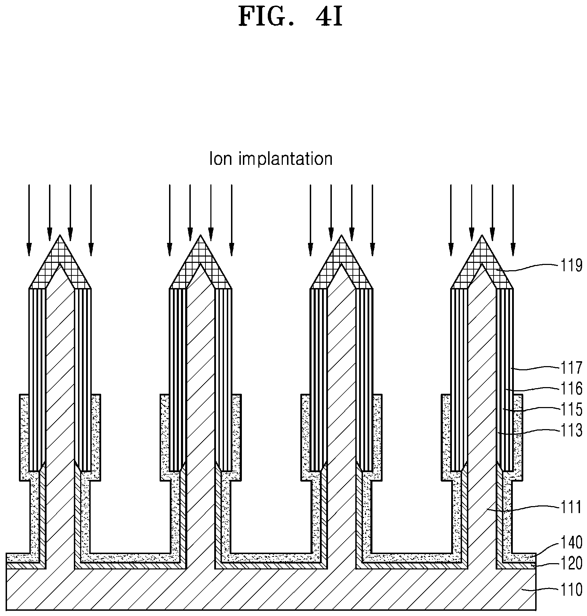

Referring to FIG. 4I, the insulating layer 140 is etched to a predetermined height, and a light emission disabling process is performed with respect to a light-emitting structure formed on the second surface 111b of the first-type semiconductor nanocore 111.

Photoresist ashing and wet etching may be used to etch the insulating layer 140.

The light emission disabling process is performed by using an ion implantation method, and a portion of the light-emitting structure where a point defect concentration is increased becomes the light emission disabling region 119.

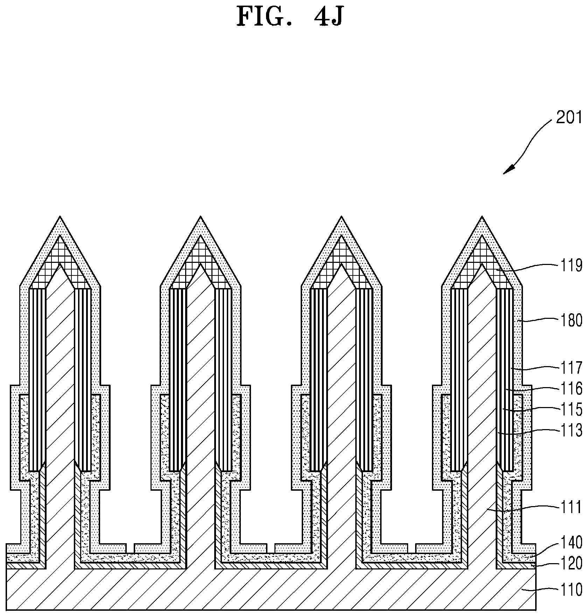

Referring to FIG. 4J, an electrode layer 180 is formed on the structure of FIG. 4I. A material of the electrode layer 180 may include a transparent conductive material, such as ITO or IGZO, or a reflective metal material such as Al.

A nanorod light-emitting device 201 manufactured in this way may be in the form of an array of a plurality of nanorod light-emitting devices 101 of FIG. 1.

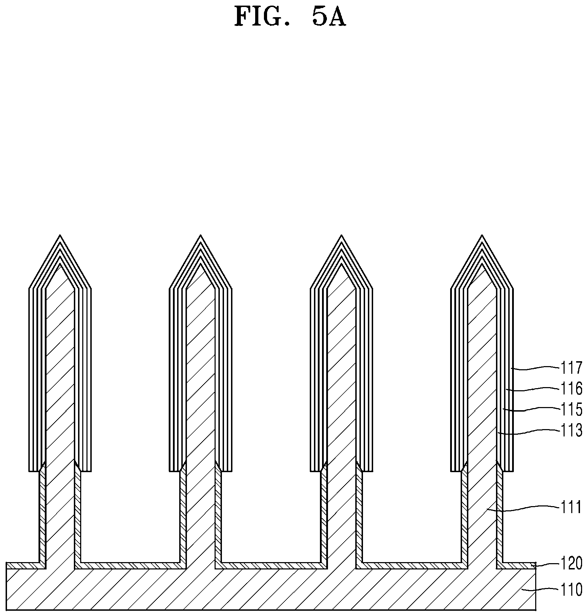

FIGS. 5A to 5C are diagrams illustrating a method of manufacturing a nanorod light-emitting device according to another example embodiment.

The manufacturing method according to an example embodiment differs from the manufacturing method described with reference to FIGS. 4A to 4J in that the light emission disabling process is not performed.

For example, in a structure manufactured as shown in FIG. 5A, both the first surface 111a, which is a non-polar surface, and the second surface 111b, which is a semi-polar surface, of the first-type semiconductor nanocore 111 may be utilized.

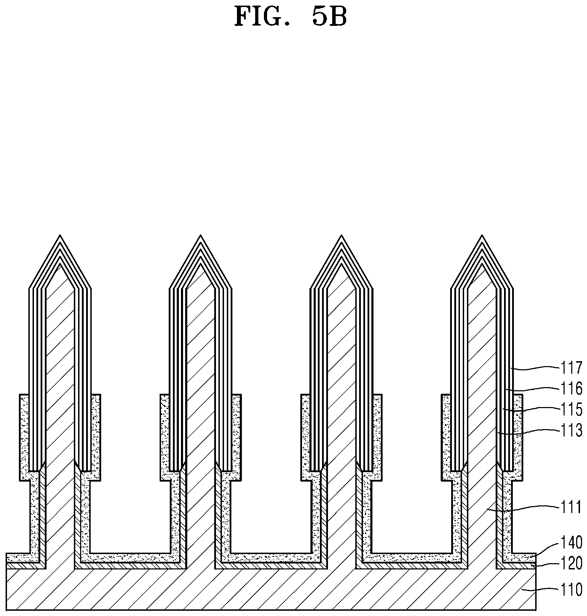

As shown in FIG. 5B, an insulating layer 140 may be formed to prevent leakage current in the vicinity adjacent to one end of the mask layer 120.

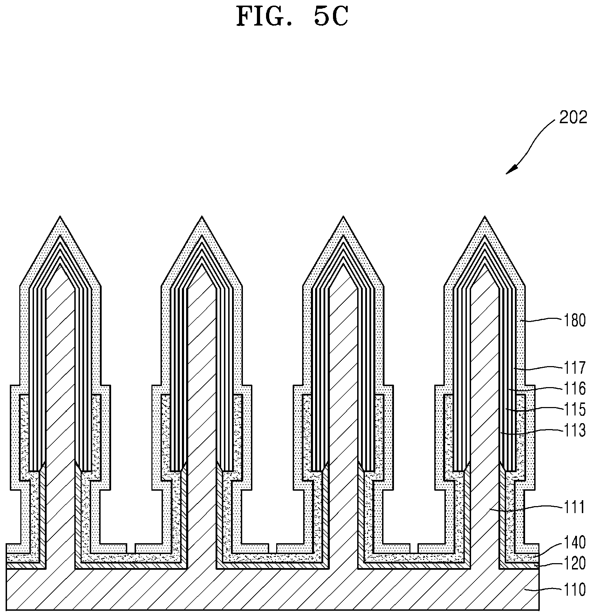

As shown in FIG. 5C, an electrode layer 180 is further formed. The nanorod light-emitting device 202 manufactured in this way may be in the form of an array of a plurality of nanorod light-emitting devices 102 of FIG. 2.

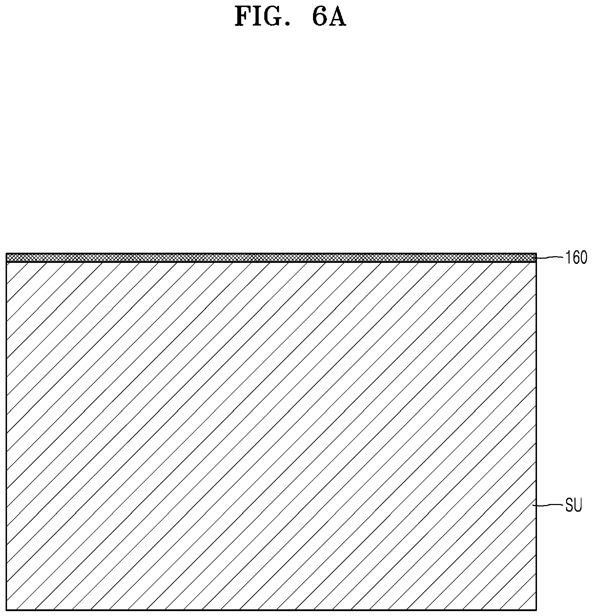

FIGS. 6A to 6J are diagrams illustrating a method of manufacturing a nanorod light-emitting device 103 according to another example embodiment.

Referring to FIG. 6A, a hard mask layer 160 is formed on a semiconductor substrate SU.

The semiconductor substrate SU may include an n-type doped semiconductor material. The semiconductor substrate SU may include, for example, an n-GaN substrate.

The hard mask layer 160 may include the same material as the mask layer 120 described above, or a material having a lower etch selectivity than an etch selectivity of the mask layer 120 may be selected. The hard mask layer 160 may include, for example, a silicon oxide (SiO₂) single layer or a SiO₂/Al double layer.

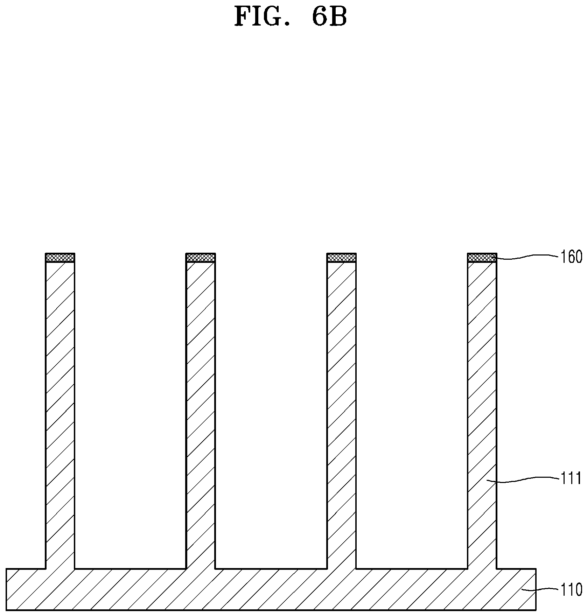

The structure of FIG. 6B may be formed by patterning and etching the structure of FIG. 6A. For example, a wet etching method using a tetramethyl ammonium hydroxide (TMAH) solution or a potassium hydroxide (KOH) solution may be used as an etchant. Referring to FIG. 6B, a structure in which a plurality of first-type semiconductor nanocores 111 protrude is provided on the support layer 110. A patterned mask layer 120 remains on the top of the first-type semiconductor nanocore 111.

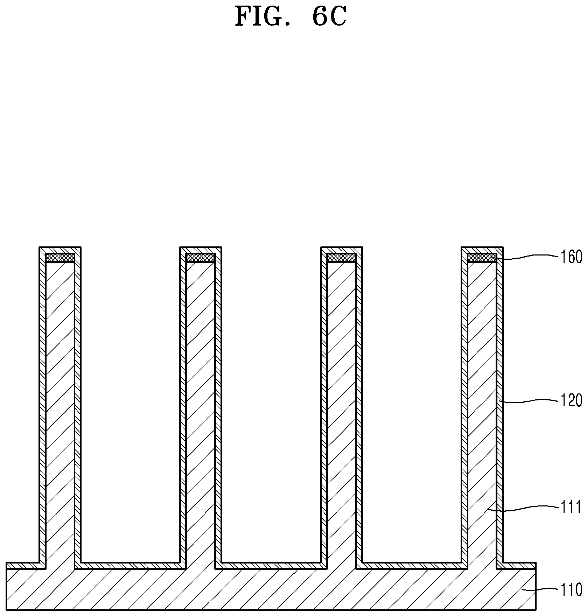

Referring to FIG. 6C, a mask layer 120 is formed along surfaces of the first-type semiconductor nanocores 111. The mask layer 120, as an insulating material, may include silicon oxide or silicon nitride, for example, SiO₂, TiO₂, Si3N₄, Al₂O₃, TiN, AlN, ZrO₂, TiAlN, TiSiN, etc. and may be formed by using an ALD method. The mask layer 120 may be formed conformally along surface of the support layer 110 and the surfaces of the plurality of first-type semiconductor nanocores 111.

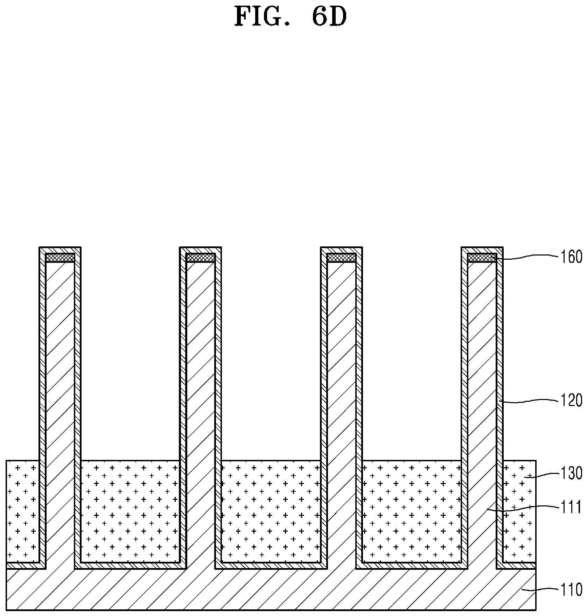

Referring to FIG. 6D, a photoresist layer 130 is formed. The photoresist layer 130 having a height shown may be formed by coating a photoresist material and ashing.

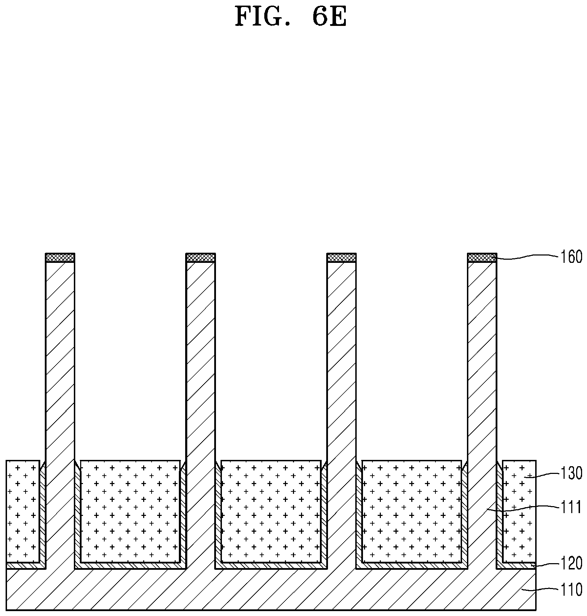

Referring to FIG. 6E, a portion of the mask layer 120 positioned at a height higher than the photoresist layer 130 is etched. A wet etching method using an etchant having a high etch selectivity with respect to the material of the mask layer 120 may be used. Due to the difference in etch selectivity, an upper end of the mask layer 120 may be etched more than the photoresist layer 130, resulting in a tapered shape.

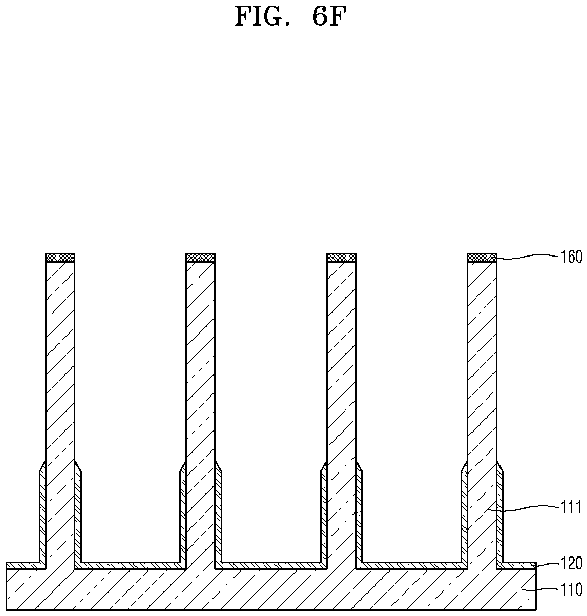

Referring to FIG. 6F, the photoresist layer 130 is removed. Accordingly, a structure including the mask layer 120 covering lower sides of the first-type semiconductor nanocore 111 and a hard mask layer 160 covering a top of the first-type semiconductor nanocore 111 is formed.

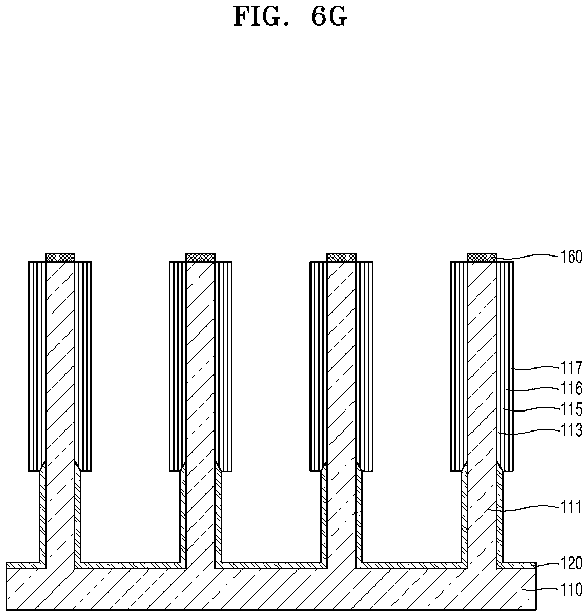

Referring to FIG. 6G, a light-emitting layer 115 is grown from the surface of the first-type semiconductor nanocore 111. As shown in FIG. 6F, a superlattice layer 113, a light-emitting layer 115, an electron blocking layer 116, and a second-type semiconductor layer 117 may be sequentially formed in a shape surrounding a first surface 111a of the first-type semiconductor nanocore 111.

In the process of manufacturing these semiconductor layers, as the hard mask layer 160 is formed at the top of the first-type semiconductor nanocore 111, the first-type semiconductor nanocore 111 may not grow in the height direction (Z direction). Therefore, the superlattice layer 113, the light-emitting layer 115, the electron blocking layer 116, and the second-type semiconductor layer 117 are sequentially formed using the first surface 111a, which is a non-polar surface, as a growth surface.

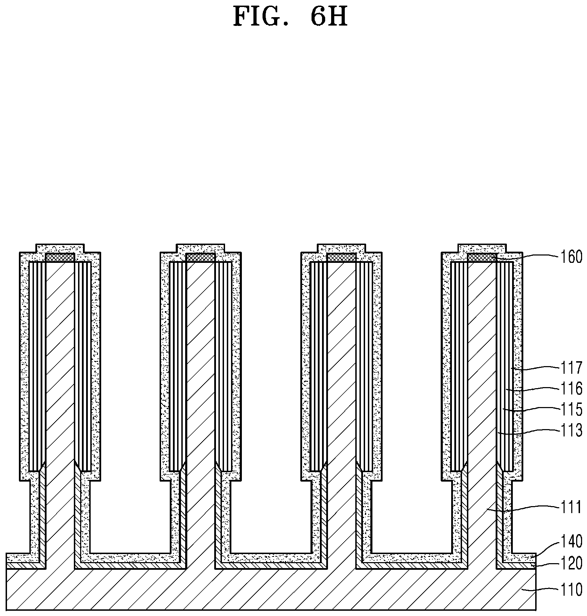

Referring to FIG. 6H, an insulating layer 140 is conformally formed on the structure shown in FIG. 6G. The insulating layer 140 is formed to prevent leakage current that may occur near an end of the mask layer 120.

The insulating layer 140 may include, for example, ZrO, SrO, MgO, BaO, CeO₂, Gd₂O₃, CaO, HfO₂, TiO₂, AlOₓ, BaN, SiN, TiN, CeN, AlN, ZnSe, ZnS, AlGaN, or AlₓGa₁₋ₓAs (x ≥ 0.9). The insulating layer 140 may be formed by using an atomic layer deposition (ALD) method.

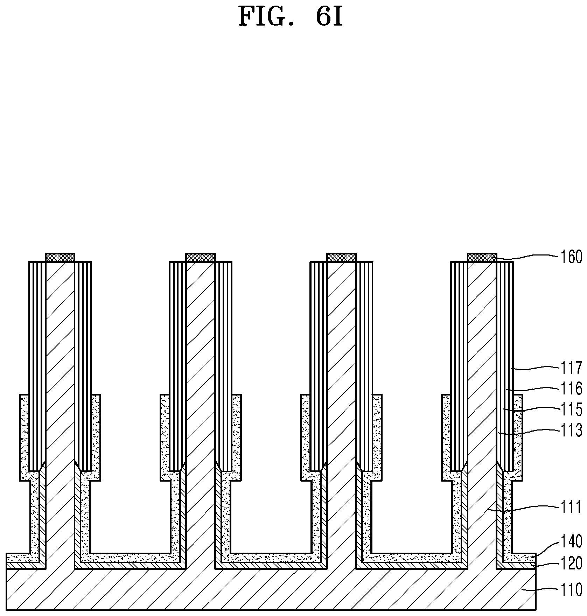

Referring to FIG. 6I, the insulating layer 140 is etched to a predetermined height. Photoresist ashing and wet etching may be used to etch the insulating layer 140.

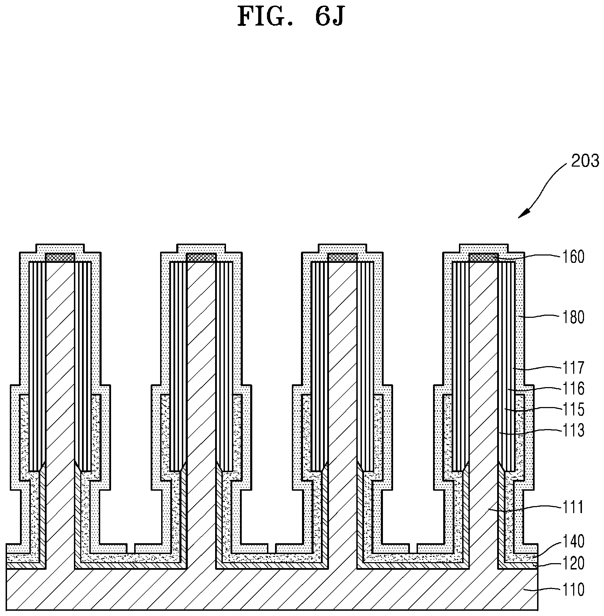

Referring to FIG. 6J, an electrode layer 180 is formed on the structure of FIG. 6I. A material of the electrode layer 180 may be a transparent conductive material or a reflective metal material.

The nanorod light-emitting device 203 manufactured in this way may be in the form of an array of a plurality of nanorod light-emitting devices 103 of FIG. 3.

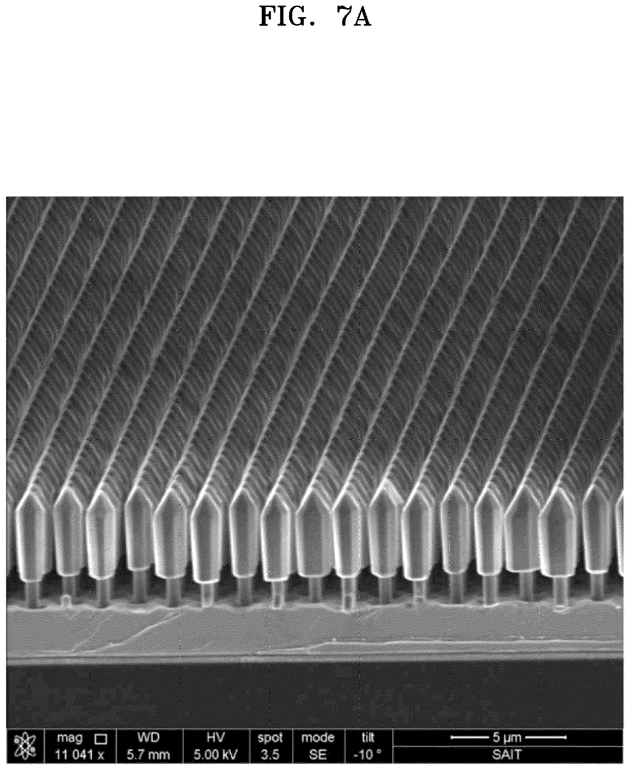

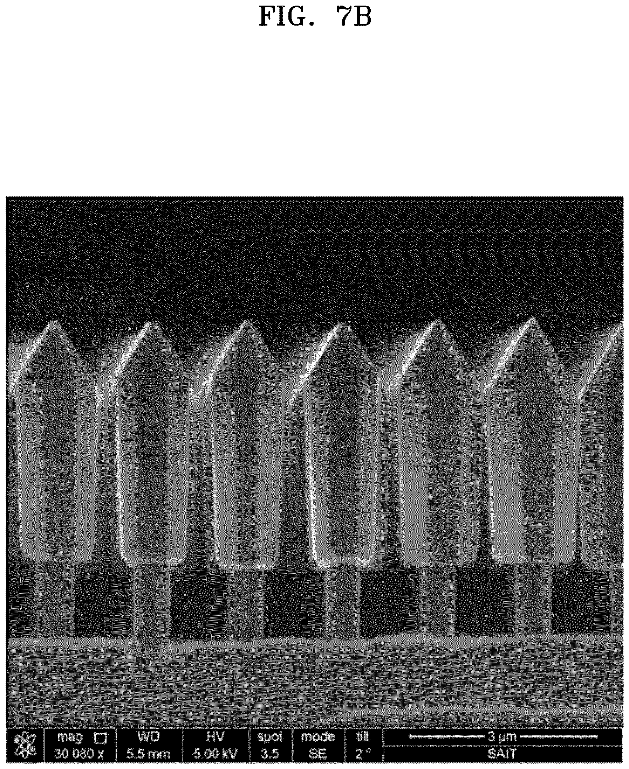

FIGS. 7A and 7B show micrographs of a nanorod light-emitting device manufactured according to the method of manufacturing a nanorod light-emitting device, according to an example embodiment.

FIG. 7B is an enlarged photograph of a portion of FIG. 7A. FIGS. 7A and 7B show that nanorod light-emitting devices having a diameter of approximately 1 µm or less may be implemented through the manufacturing method described above.

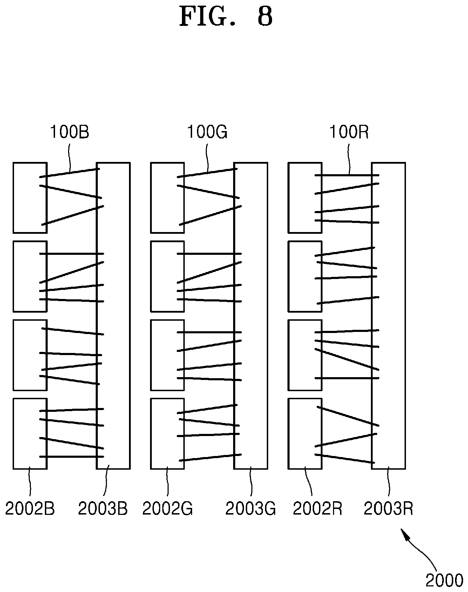

The nanorod light-emitting devices 101, 102, and 103 according to the example embodiments described above may be used in various applications. In particular, nanorod light-emitting devices may be used as light-emitting elements in pixels of next-generation display devices. For example, FIG. 8 is a conceptual diagram schematically showing a configuration of a display apparatus using a nanorod light-emitting device, according to an example embodiment. Referring to FIG. 8, the display apparatus 2000 may include a plurality of first pixel electrodes 2002B, a first common electrode 2003B corresponding to the plurality of first pixel electrodes 2002B, a plurality of second pixel electrodes 2002G, a second common electrode 2003G corresponding to the plurality of second pixel electrodes 2002G, a plurality of third pixel electrodes 2002R, a third common electrode 2003R corresponding to the plurality of third pixel electrodes 2002B, a plurality of first nanorod light-emitting devices 100B connected between each of the first pixel electrodes 2002B and the first common electrode 2003B, a plurality of second nanorod light emitting devices 100G connected between each of the second pixel electrodes 2002G and the second common electrode 2003G, and a plurality of third nanorod light-emitting devices 100R connected between each third pixel electrode 2002R and the third common electrode 2003R.

For example, the first nanorod light-emitting device 100B may be configured to emit blue light, the second nanorod light-emitting device 100G may be configured to emit green light, and the third nanorod light-emitting device 100R may be configured to emit red light. Also, one first pixel electrode 2002B may form one blue sub-pixel together with the first common electrode 2003B, one second pixel electrode 2002G may form one green sub-pixel together with the second common electrode 2003G, and one third pixel electrode 2002R may form one red sub-pixel together with the third common electrode 2003R.

The first nanorod light-emitting device 100B, the second nanorod light-emitting device 100G, and the third nanorod light-emitting device 100R may each be any one of the nanorod light-emitting devices 101, 102, and 103 described above.

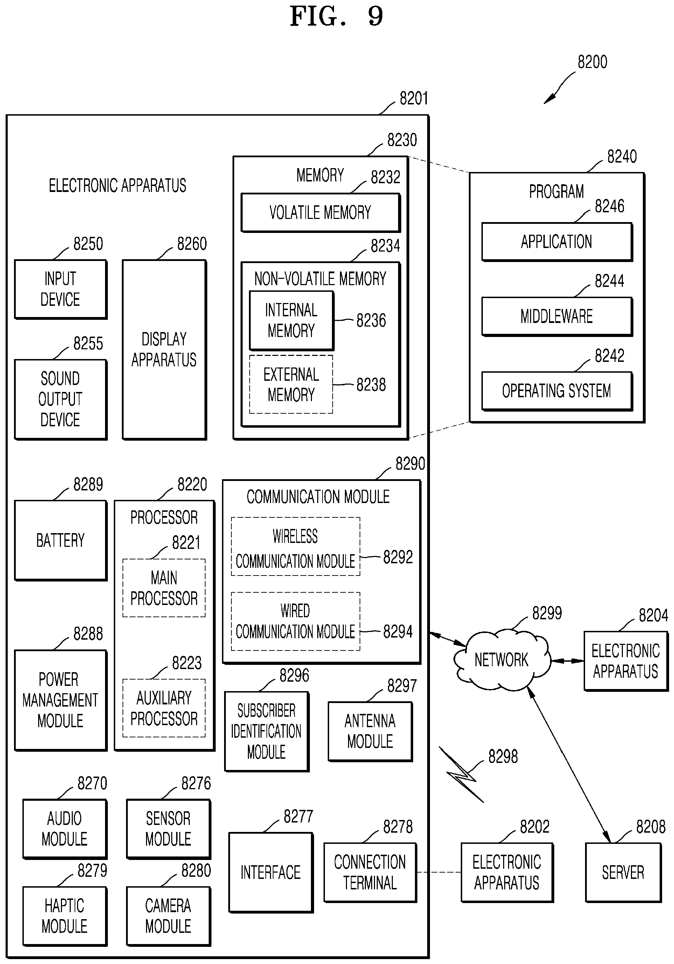

The nanorod light-emitting devices 101, 102, and 103 according to the example embodiments described above may be applied to display apparatuses of various sizes and for various purposes without limitation. For example, FIGS. 9 to 14 show various apparatuses including a display apparatus to which nanorod light-emitting devices according to the example embodiments are applied.

First, FIG. 9 is a schematic block diagram of an electronic apparatus according to an example embodiment. Referring to FIG. 9, an electronic apparatus 8201 may be provided in a network environment 8200. In the network environment 8200, the electronic apparatus 8201 may communicate with another electronic apparatus 8202 through a first network 8298 (a short-range wireless communication network, etc.), or may communicate with another electronic apparatus 8204 and/or a server 8208 through a second network 8299 (a long-distance wireless communication network). The electronic device 8201 may communicate with the electronic apparatus 8204 through the server 8208. The electronic apparatus 8201 may include a processor 8220, a memory 8230, an input device 8250, an audio output device 8255, a display apparatus 8260, an audio module 8270, a sensor module 8276, and an interface 8277, a haptic module 8279, a camera module 8280, a power management module 8288, a battery 8289, a communication module 8290, a subscriber identification module 8296, and/or an antenna module 8297. In the electronic apparatus 8201, some of these components may be omitted or other components may be added. Some of these components may be implemented as one integrated circuit. For example, the sensor module 8276 (a fingerprint sensor, an iris sensor, an illumination sensor, etc.) may be implemented by being embedded in the display apparatus 8260 (a display, etc.).

The processor 8220 may execute software (a program 8240, etc.) to control one or a plurality of other components (hardware, software components, etc.) of the electronic apparatus 8201 connected to the processor 8220 and may perform various data processing or operations. As part of data processing or computation, the processor 8220 may load instructions and/or data received from other components (the sensor module 8276, the communication module 8290, etc.) into a volatile memory 8232, process commands and/or data stored in the volatile memory 8232, and store the resulting data in a non-volatile memory 8234. The non-volatile memory 8234 may include an internal memory 8236 mounted within the electronic apparatus 8201 and a removable external memory 8238. The processor 8220 may include a main processor 8221 (a central processing unit, an application processor, etc.) and an auxiliary processor 8223 (a graphics processing unit, an image signal processor, a sensor hub processor, a communication processor, etc.) that may be operated independently or together with the main processor 8221. The auxiliary processor 8223 may use less power than the main processor 8221 and may perform a specialized function.

The auxiliary processor 8223 may control functions and/or states related to some of the components (e.g., the display device 8260, the sensor module 8276, the communication module 8290) of the electronic apparatus 8201 instead of the main processor 8221 while the main processor 8221 is in an inactive state (asleep state), or together with the main processor 8221 while the main processor 8221 is in an active state (an application execution state). The auxiliary processor 8223 (an image signal processor, a communication processor, etc.) may be implemented as part of other functionally related components (the camera module 8280, the communication module 8290, etc.).

The memory 2230 may store various data required by components (the processor 8220, the sensor module 8276, etc.) of the electronic apparatus 8201. Data may include, for example, input data and/or output data for software (such as a program 8240) and instructions related to the command. The memory 8230 may include volatile a memory 8232 and/or a non-volatile memory 8234.

The program 8240 may be stored as software in the memory 8230 and may include an operating system 8242, middleware 8244, and/or applications 8246.

The input device 8250 may receive commands and/or data to be used in components (such as the processor 8220) of the electronic apparatus 8201 from the outside of the electronic apparatus 8201 (such as a user). The input device 8250 may include a remote controller, a microphone, a mouse, a keyboard, and/or a digital pen (e.g., a stylus pen, etc.).

The sound output device 8255 may output sound signals to the outside of the electronic apparatus 8201. The sound output device 8255 may include a speaker and/or a receiver. The speaker may be used for general purposes, such as multimedia playback or recording playback, and the receiver may be used to receive incoming calls. The receiver may be integrated as part of the speaker or implemented as a separate, independent device.

The display apparatus 8260 may visually provide information to the outside of the electronic apparatus 8201. The display device 8260 may include a display, a hologram device, or a projector, and a control circuit for controlling the corresponding apparatus. The display apparatus 8260 may include any one of the nanorod light-emitting devices 100, 101, and 102 described above or a light-emitting device modified therefrom as a display pixel. The display apparatus 8260 may further include a touch circuitry configured to detect a touch, and/or a sensor circuit configured to measure the intensity of force generated by the touch (such as a pressure sensor, etc.).

The audio module 8270 may convert sound into an electrical signal or, conversely, convert an electrical signal into sound. The audio module 8270 may acquire a sound through the input device 8250 or may output a sound through a speaker and/or headphone of the sound output apparatus 8255 and/or another electronic apparatus (e.g., the electronic apparatus 8202) directly or wirelessly connected to electronic apparatus 8201.

The sensor module 8276 may detect an operating state (power, temperature, etc.) of the electronic apparatus 8201 or an external environmental state (user state, etc.) and may generate an electrical signal and/or data value corresponding to the detected state. The sensor module 8276 may include a gesture sensor, a gyro sensor, a barometric pressure sensor, a magnetic sensor, an acceleration sensor, a grip sensor, a proximity sensor, a color sensor, an Infrared (IR) sensor, a biometric sensor, a temperature sensor, a humidity sensor, and/or an illumination sensor.

The interface 8277 may support one or more designated protocols that may be used by the electronic apparatus 8201 to connect the electronic apparatus 8201 directly or wirelessly with another electronic apparatus (e.g., the electronic apparatus 8102). The interface 8277 may include a High Definition Multimedia Interface (HDMI), a Universal Serial Bus (USB) interface, an SD card interface, and/or an audio interface.

The connection terminal 8278 may include a connector through which the electronic apparatus 8201 may be physically connected to another electronic apparatus (such as the electronic apparatus 8202). The connection terminal 8278 may include an HDMI connector, a USB connector, an SD card connector, and/or an audio connector (e.g., a headphone connector).

The haptic module 8279 may convert electrical signals into mechanical stimulation (vibration, movement, etc.) or electrical stimulation that the user may perceive through tactile or kinesthetic sense. Haptic module 8279 may include a motor, piezoelectric element, and/or electrical stimulation device.

The camera module 8280 may capture still images and moving images. The camera module 8280 may include a lens assembly including one or more lenses, image sensors, image signal processors, and/or flashes. The lens assembly included in the camera module 8280 may collect light emitted from an object that is the target of image capture.

The power management module 8288 may manage power supplied to the electronic apparatus 8201. The power management module 8388 may be implemented as part of a Power Management Integrated Circuit (PMIC).

The battery 8289 may supply power to components of electronic apparatus 8201. The battery 8289 may include a non-rechargeable primary cell, a rechargeable secondary cell, and/or a fuel cell.

The communication module 8290 may establish a direct (wired) communication channel and/or a wireless communication channel between the electronic apparatus 8201 and other electronic apparatus (the electronic apparatus 8202, the electronic apparatus 8204, the server 8208, etc.), and may support communication through the established communication channels. The communication module 8290 may include one or more communication processors that operate independently of the processor 8220 (e.g., an application processor) and support direct communication and/or wireless communication. The communication module 8290 may include a wireless communication module 8292 (a cellular communication module, a short-range wireless communication module, a Global Navigation Satellite System (GNSS, etc.) communication module) and/or a wired communication module 8294 (a Local Area Network (LAN) communication module, or a power line communication module, etc.). Among these communication modules, a corresponding communication module may communicate with other electronic apparatuses through the first network 8298 (a short-range communication network, such as Bluetooth, WiFi Direct, or Infrared Data Association (IrDA)) or the second network 8299 (a telecommunication network, such as a cellular network, the Internet, or a computer network (LAN and WAN, etc.). The various types of communication modules may be integrated into one component (a single chip, etc.) or implemented as a plurality of components (plural chips) separate from each other. The wireless communication module 8292 may identify and authenticate the electronic apparatus 8201 within a communication network, such as the first network 8298 and/or the second network 8299 by using subscriber information (such as, International Mobile Subscriber Identifier (IMSI)) stored in a subscriber identification module 8296.

The antenna module 8297 may transmit or receive signals and/or power to and from the outside (other electronic apparatuses, etc.). The antenna may include a radiator having a conductive pattern formed on a substrate (a PCB, etc.). The antenna module 8297 may include one or a plurality of antennas. When a plurality of antennas is included in the antenna module 2297, an antenna suitable for a communication method used in a communication network, such as the first network 8298 and/or the second network 8299 may be selected from among the plurality of antennas by the communication module 8290. Signals and/or power may be transmitted or received between the communication module 8290 and other electronic apparatus through the selected antenna. In addition to the antenna, other components (an RFIC, etc.) may be included as part of the antenna module 8297.

Some of the components are connected to each other through a communication method between peripheral devices (a bus, a General Purpose Input and Output (GPIO), a Serial Peripheral Interface (SPI), a Mobile Industry Processor Interface (MIPI), etc.), and may interchange signals (commands, data, etc.).

Commands or data may be transmitted or received between the electronic apparatus 8201 and an external electronic apparatus 8204 through the server 8208 connected to the second network 8299. Other electronic apparatuses 8202 and 8204 may be the same or different types of apparatuses from the electronic apparatus 8201. All or some of operations performed on the electronic apparatus 8201 may be executed on one or more of the other electronic apparatuses 8202, 8204, and 8208. For example, when the electronic apparatus 8201 needs to perform a certain function or service, the electronic apparatus 2201 may request one or more other electronic apparatuses to perform some or all function or service instead of executing the function or service itself. One or more other electronic apparatuses that have received the request may execute additional functions or services related to the request and transmit the results of the execution to the electronic apparatus 8201. For this purpose, cloud computing, distributed computing, and/or client-server computing technologies may be used.

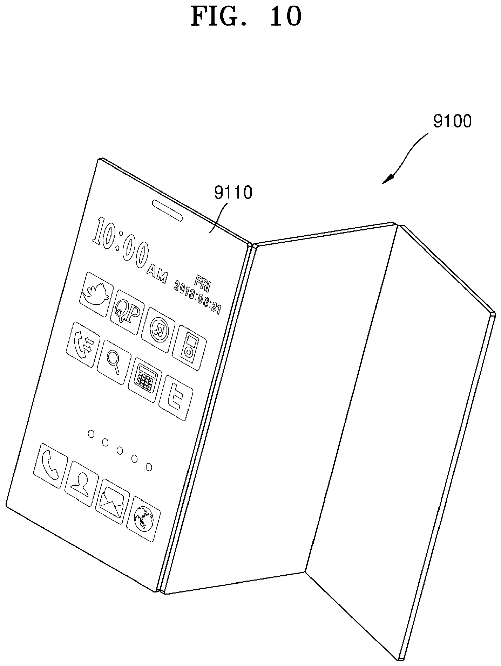

FIG. 10 shows an example of an application of a display apparatus according to an example embodiment to a mobile device. The mobile apparatus 9100 may include a display apparatus 9110, and the display apparatus 9110 may include any one of the nanorod light-emitting devices 101, 102, and 103 described above or a light-emitting device having a structure modified therefrom as a pixel. The display device 9110 may have a foldable structure, for example, a multi-foldable structure.

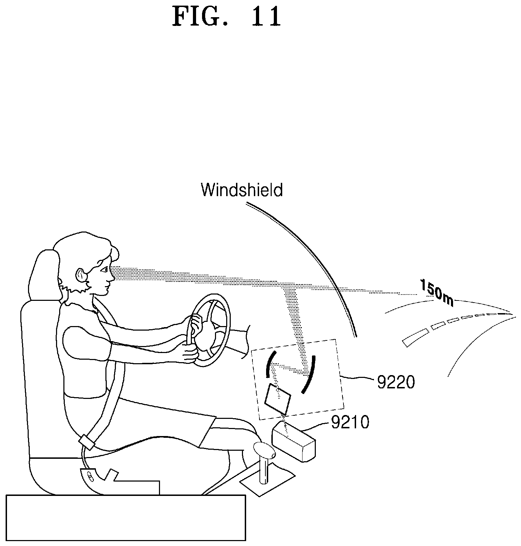

FIG. 11 shows an example of an application of a display apparatus according to an example embodiment to a vehicle display apparatus. The display apparatus may be a head-up display apparatus 9200 for a vehicle, and may include a display 9210 provided in one area of the vehicle and an optical path change member 9220 that converts an optical path so that a driver may view an image generated by the display 9210.

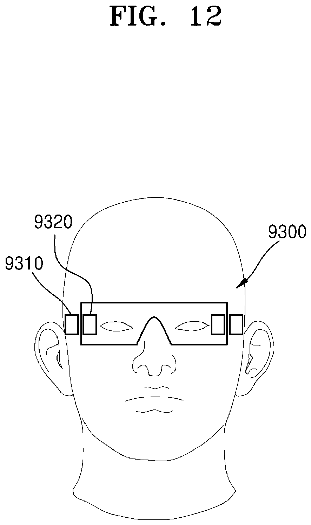

FIG. 12 shows an example of an application of a display apparatus according to an example embodiment to augmented reality glasses or virtual reality glasses. The augmented reality glasses 9300 may include a projection system 9310 that forms an image and an element 9320 that guides an image from the projection system 9310 to enter a user's eyes. The projection system 9310 may include any one of the nanorod light emitting devices 101, 102, and 103 described above, or a light-emitting device having a structure modified therefrom.

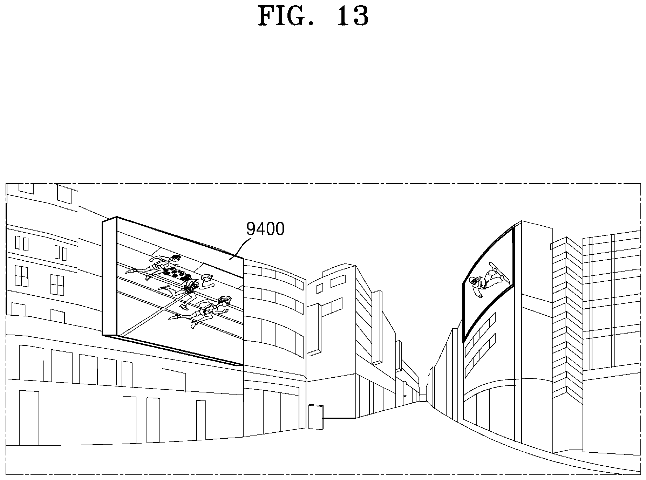

FIG. 13 shows an example of an application of a display apparatus according to an example embodiment to a signage. The signage 9400 may be used for outdoor advertising using a digital information display, and may control advertising content through a communication network. The signage 9400 may be implemented through, for example, the electronic apparatus described with reference to FIG. 9.

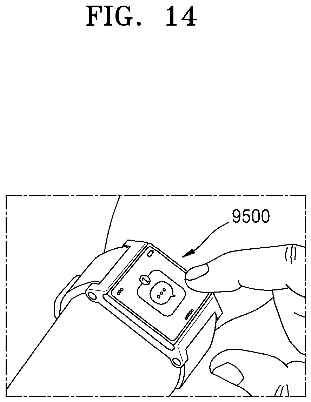

FIG. 14 shows an example of an application of a display apparatus according to an example embodiment to a wearable display. The wearable display 9500 may include any one of the nanorod light-emitting devices 101, 102, and 103 described above, or a light-emitting device having a structure modified therefrom, and may be implemented through the electronic apparatus described with reference to FIG. 9.

The display apparatus according to an embodiment may also be applied to various products, such as rollable television (TV) and stretchable display.

The nanorod light emitting device includes a light-emitting layer grown on a non-polar surface, and thus, light emission efficiency is relatively high and the full width at half maximum of the light emission spectrum may be reduced.

According to the method of manufacturing the nanorod light-emitting device described above, a light-emitting structure including a high-quality semiconductor thin film with high uniformity and few defects may be implemented.

The nanorod light emitting device described above may be applied as a display pixel to various types of electronic apparatuses.

The nanorod light-emitting device described above, the manufacturing method thereof, and a display apparatus including the nanorod light-emitting device have been described with reference to the embodiments shown in the drawings. However, it will be understood by those of ordinary skill in the art that various changes in form and details may be made therein without departing from the scope of the disclosure. Therefore, the example embodiments should be considered in a descriptive sense only and not for purposes of limitation. The scope of the disclosure is defined not by the detailed description of the disclosure but by the appended claims, and all differences within the scope will be construed as being included in the disclosure.

It should be understood that example embodiments described herein should be considered in a descriptive sense only and not for purposes of limitation. Descriptions of features or aspects within each example embodiment should typically be considered as available for other similar features or aspects in other embodiments. While example embodiments have been described with reference to the figures, it will be understood by those of ordinary skill in the art that various changes in form and details may be made therein without departing from the scope as defined by the following claims and their equivalents.

## Claims

1. A nanorod light-emitting device comprising:
a support layer;
a first-type semiconductor nanocore protruding from an upper surface of the support layer and comprising a semiconductor material doped as a first conductivity type;
a mask layer on an upper surface of the support layer and extending to a first height of the first-type semiconductor nanocore in a vertical direction and adjacent to a surface of the first-type semiconductor nanocore;
a light-emitting layer having a multi-quantum well structure adjacent to a portion of the first-type semiconductor nanocore above the first height in the vertical direction; and
a second-type semiconductor layer adjacent to a surface of the light-emitting layer and comprising a semiconductor material doped as a second conductivity type.

2. The nanorod light-emitting device of claim 1, wherein the support layer and the first-type semiconductor nanocore are integrally formed.

3. The nanorod light-emitting device of claim 1 or 2, wherein a first end of the mask layer has a tapered shape.

4. The nanorod light-emitting device of any preceding claim, wherein the first height is greater than or equal to 5 % of a height of the first-type semiconductor nanocore.

5. The nanorod light-emitting device of any preceding claim, further comprising an insulating layer extending from a lower surface of the mask layer to a second height of the first-type semiconductor nanocore in the vertical direction and adjacent to the mask layer and the light-emitting layer, and optionally wherein the second height is greater than the first height.

6. The nanorod light-emitting device of any preceding claim, wherein the first-type semiconductor nanocore comprises:
a first portion having a uniform cross-sectional area in a horizontal direction perpendicular to the vertical direction of the first-type semiconductor nanocore; and
a second portion having a cross-sectional area in the horizontal direction decreasing in the vertical direction away from the support layer, and optionally wherein a region of the light-emitting layer and a region of the second-type semiconductor layer on the second portion is a light emission disabling region.

7. The nanorod light-emitting device of any preceding claim, further comprising a hard mask layer on top of the first-type semiconductor nanocore.

8. The nanorod light-emitting device of any preceding claim, further comprising a super lattice layer between the first-type semiconductor nanocore and the light-emitting layer.

9. The nanorod light-emitting device of any preceding claim, further comprising an electron blocking layer between the light-emitting layer and the second-type semiconductor layer.

10. A display apparatus comprising:
a plurality of pixel electrodes;
a common electrode corresponding to the plurality of pixel electrodes; and
a plurality of nanorod light-emitting devices according to any preceding claim connected between each pixel electrode of the plurality of pixel electrodes and the common electrode.

11. A method of manufacturing a nanorod light-emitting device, the method comprising:
forming a first-type semiconductor nanocore protruding from a support layer in a first direction;
forming a mask layer adjacent to lower sides of the first-type semiconductor nanocore; and
growing a light-emitting structure layer from a surface of the first-type semiconductor nanocore in a direction different from the first direction.

12. The method of claim 11, further comprising, after forming a hard mask layer on the semiconductor substrate, patterning the semiconductor substrate and the hard mask layer together.

13. The method of claim 11 or 12, wherein the growing of the light-emitting structure layer comprises sequentially forming a super lattice layer, a light-emitting layer, an electron blocking layer, and a second-type semiconductor layer.

14. The method of claim 13, further comprising, after the growing of the light-emitting structure layer, disabling light emission of the light-emitting structure layer formed on a semi-polar surface on a top of the first-type semiconductor nanocore, among the light-emitting structure layer.

15. The method of any of claims 11 to 14, further comprising, after growing the light-emitting structure layer, forming an insulating layer adjacent to an end of the mask layer and the light-emitting structure layer.
